# EUROPEAN PATENT APPLICATION

(11) **EP 4 138 135 A1**
(43) Date of publication of application: **22.02.2023**
(21) Application number: 22743699.5
(22) Date of filing: 15.02.2022
(51) Int. Cl.: H01L 27/108

(54) **STORAGE UNIT AND PREPARATION METHOD THEREFOR, AND MEMORY AND PREPARATION METHOD THEREFOR**

(30) Priority: 02.07.2021 CN 202110753695
(71) Applicant: Changxin Memory Technologies, Inc., Hefei City, Anhui 230000 (CN)
(72) Inventor: XIAO, Deyuan, Hefei City, Anhui 230000 (CN)
(74) Representative: Lavoix
(86) International application number: PCT/CN2022/076315
(87) International publication number: WO 2023/273361

(57) **Abstract**

The present disclosure provides a memory cell and a manufacturing method thereof, and a memory and a manufacturing method thereof, and relates to the technical field of semiconductors. The memory unit includes a first dielectric layer and a second dielectric layer that are stacked. A first transistor is disposed in the first dielectric layer. A second transistor is disposed in the second dielectric layer. The first dielectric layer is connected to the second dielectric layer by using a connecting wire. In the present disclosure, a parasitic capacitance in the first transistor or the second transistor is used as a memory element to replace the capacitor in the related art, such that the volume occupied by the memory cells can be reduced, to ensure that the memory cells are developed in an integration direction. In addition, the first transistor and the second transistor are both metal-oxide thin-film transistors, such that the memory can have longer retention time of charge, to improve the performance of the memory while decreasing the volume of the memory.

## Description

### Cross-Reference to Related Applications

The present disclosure claims the priority to Chinese Patent Application 202110753695.0, titled "MEMORY CELL AND MANUFACTURING METHOD THEREOF, AND MEMORY AND MANUFACTURING METHOD THEREOF", filed with China National Intellectual Property Administration (CNIPA) on July 2, 2021, which is incorporated herein by reference in its entirety.

### Technical Field

The present disclosure relates to the technical field of semiconductors, and in particular, to a memory cell and a manufacturing method thereof, and a memory and a manufacturing method thereof.

### Background

A dynamic random access memory (DRAM) is a semiconductor memory that randomly writes and reads data at high speed, and is widely used in data storage devices or apparatuses.

The DRAM usually includes a base, a memory cell array formed by a plurality of repeated memory cells, and a peripheral circuit that are disposed on the base. The plurality of memory cells are arranged at intervals along a direction parallel to the base. Each of the memory cells usually includes a capacitor structure and a transistor of which a gate is connected to a word line in the memory cell array, a drain is connected to a bit line in the memory cell array, and a source is connected to the capacitor structure.

However, the structure is not suitable to manufacture small-sized memories.

### Summary

A first aspect of embodiments of the present disclosure provides a manufacturing method of a memory cell, including:
a first transistor, located in a first dielectric layer;
a second transistor, located in a second dielectric layer, wherein the second dielectric layer is located above the first dielectric layer; and
a connecting wire, located in the first dielectric layer and the second dielectric layer, wherein one end of the connecting wire is connected to the first transistor, and the other end is connected to the second transistor; and
the first transistor and the second transistor are metal-oxide thin-film transistors.

A second aspect of the embodiments of the present disclosure provides a memory, including:
a base, wherein a peripheral circuit is disposed on a surface of the base;
a plurality of the memory cells described above, located above the peripheral circuit; and
a data line, configured to connect the peripheral circuit to the memory cells.

In the memory described above, the plurality of the memory cells are arranged in a direction parallel to the base to form a horizontal array; and/or
the plurality of the memory cells are stacked in a direction perpendicular to the base to form a vertical array.

A third aspect of the embodiments of the present disclosure provides a method of manufacturing a memory cell, including:
forming a first transistor in a first dielectric layer, wherein the first transistor is a metal-oxide thin-film transistor;
forming a part of a connecting wire in the first dielectric layer, wherein one end of the connecting wire is connected to the first transistor;
forming a second dielectric layer on the first dielectric layer;
forming another part of the connecting wire in the second dielectric layer, wherein one end of the connecting wire close to the first dielectric layer is connected to the connecting wire formed in the first dielectric layer; and
forming a second transistor in the second dielectric layer, wherein the second transistor is connected to one end of the connecting wire away from the first dielectric layer, and the second transistor is a metal-oxide thin-film transistor.

A fourth aspect of the embodiments of the present application provides a method of manufacturing a memory, including:
providing a base, wherein a peripheral circuit is disposed on a surface of the base;
forming a plurality of memory cells sequentially on the base, wherein the plurality of the memory cells are arranged in a direction parallel to the base to form a horizontal array; and/or the plurality of the memory cells are stacked in a direction perpendicular to the base to form a vertical array; and the memory cell is obtained by using the foregoing method of manufacturing a memory cell;
forming a data line, wherein the data line is configured to connect the peripheral circuit to the memory cells.

In addition to the technical problems resolved by the embodiments of the present disclosure, the technical features constituting the technical solutions and the beneficial effects brought about by the technical features of these technical solutions, other technical problems to be resolved by the memory cell and the manufacturing method thereof, and the memory and the manufacturing method thereof in the embodiments of the present disclosure, other technical features included in the technical solutions and beneficial effects brought about by these technical features are further described in detail in the specific implementations.

### Brief Description of the Drawings

To describe the technical solutions in the embodiments of the present disclosure or in the prior art more clearly, the following briefly describes the drawings required for describing the embodiments or the prior art. Apparently, the drawings in the following description show some embodiments of the present disclosure, and a person of ordinary skill in the art may still derive other drawings from these drawings without creative efforts.
FIG. 1 is a schematic structural diagram of a memory cell according to Embodiment 1 of the present disclosure;
FIG. 2 is a schematic structural diagram of a memory according to Embodiment 2 of the present disclosure;
FIG. 3 is a circuit diagram of a memory according to Embodiment 2 of the present disclosure;
FIG. 4 is a process flowchart of a method of manufacturing a memory cell according to Embodiment 3 of the present disclosure;
FIG. 5 is a schematic structural diagram of an active layer formed in the method of manufacturing a memory cell according to Embodiment 3 of the present disclosure;
FIG. 6 is a schematic structural diagram of a first transistor formed in the method of manufacturing a memory cell according to Embodiment 3 of the present disclosure;
FIG. 7 is a schematic structural diagram of a second insulating layer formed in the method of manufacturing a memory cell according to Embodiment 3 of the present disclosure;
FIG. 8 is a schematic structural diagram of a first contact part and a metal wire formed in the method of manufacturing a memory cell according to Embodiment 3 of the present disclosure;
FIG. 9 is a schematic structural diagram of a second contact part and the active layer formed in the method of manufacturing a memory cell according to Embodiment 3 of the present disclosure; and
FIG. 10 is a schematic structural diagram of a second transistor formed in the method of manufacturing a memory cell according to Embodiment 3 of the present disclosure.

### Detailed Description

Based on the foregoing technical problems, embodiments of the present disclosure provide a memory cell and a manufacturing method thereof, a memory and a manufacturing method thereof. The memory cell includes a first transistor and a second transistor that are stacked. A parasitic capacitance in the first transistor or the second transistor is used as a memory element to replace the capacitor in the related art, such that the volume occupied by the memory cells can be reduced, to improve the integration of the memory cell and ensure that the memory cells are developed in an integration direction.

In addition, the first transistor and the second transistor are both metal-oxide thin-film transistors, such that the memory can have longer retention time of charge, to improve the performance of the memory while decreasing the volume of the memory.

To make the objectives, features and advantages of the embodiments of the present disclosure clearer, the technical solutions in the embodiments of the present disclosure are described clearly and completely below with reference to the drawings in the embodiments of the present disclosure. Apparently, the described embodiments are merely some rather than all of the embodiments of the present disclosure. All other embodiments obtained by those of ordinary skill in the art based on the embodiments of the disclosure without creative efforts shall fall within the protection scope of the present disclosure.

### Embodiment 1

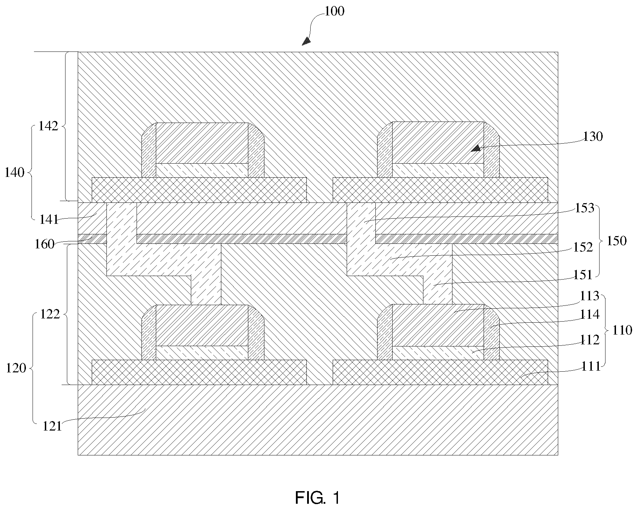

As shown in FIG. 1, this embodiment of the present disclosure provides a memory cell 100. The memory cell 100 may include a first dielectric layer 120 and a second dielectric layer 140 disposed on the first dielectric layer 120. A first transistor 110 is disposed in the first dielectric layer 120. A second transistor 130 is disposed in the second dielectric layer 140. The first transistor 110 is connected to the second transistor 130 by using a connecting wire 150 disposed in the first dielectric layer 120 and the second dielectric layer 140. The first transistor 110 and the second transistor 130 may be metal-oxide thin-film transistors.

The memory cell 100 related to this embodiment includes a first transistor 110 and a second transistor 130 that are stacked. A parasitic capacitance in the first transistor 110 or the second transistor 130 is used as a memory element to replace the capacitor in the related art, such that the volume occupied by the memory cells 100 can be reduced, to ensure that the memory cells 100 are developed in an integration direction.

In addition, the first transistor 110 and the second transistor 130 are both metal-oxide thin-film transistors, such that the memory can have longer retention time of charge, to improve the performance of the memory while decreasing the volume of the memory.

It should be noted that the first transistor 110 and the second transistor 130 are of the same structure. For ease of description, the first transistor 110 is used as an example in the following embodiment, and the structure of the first transistor 110 is described.

For example, with reference to FIG. 1, the first transistor 110 includes an active layer 111, a gate oxide layer 112, and a gate 113. The active layer 111 includes a channel region, and a source and a drain that are respectively located at two sides of the channel region. The gate oxide layer 112 and the gate 113 are stacked sequentially on the active layer 111. Projection of the gate 113 on the active layer 111 covers the channel region, such that there is an overlapping region between the gate 113 and the active layer 111. In this way, when a voltage difference is generated between the active layer 111 and the gate 113, a capacitance is formed between the gate 113 and the active layer 111. The capacitance is used as a memory element of the memory cell, to read or write data.

In addition, in this embodiment, a material of the active layer 111 may include an indium gallium zinc oxide, which has higher carrier mobility, thereby greatly improving the sensitivity of the first transistor and reducing the power consumption of the memory cell.

A material of the gate oxide layer 112 may include silicon oxide and/or aluminum oxide, and the material of the gate 113 may include one of the group consisting of titanium nitride, tantalum nitride, aluminum and tungsten.

It should be noted that in this embodiment, the projection of the gate 113 on the active layer 111 covers the channel region, which may be understood to be that an area of the projection of the gate 113 on the active layer 111 is equal to that of the channel region or that the area of the projection of the gate 113 on the active layer 111 is smaller than that of the channel region.

Further, the first transistor 110 further includes a protective layer 114. The protective layer 114 is located at sides of the gate 113 and of the gate oxide layer 112. The protective layer 114 is disposed to electrically isolate the gate from other members.

In some embodiments, the connecting wire 150 may have one end connected to the gate of the first transistor 110, and the other end connected to the source or drain of the second transistor 130. An electrical signal on the source or drain of the second transistor 130 is used to control the first transistor 110 to open or close.

It should be noted that the shape of the connecting wire 150 may be arbitrary. For example, the connecting wire 150 may be a straight line or a folded line.

For example, the connecting wire 150 includes a first contact part 151, a metal wire 152 and a second contact part 153. The first contact part 151 and the second contact part 153 extend in a vertical direction. That is, the first contact part 151 and the second contact part 153 are disposed in a direction perpendicular to the first dielectric layer 120. The metal wire 152 extends in a horizontal direction. One end of the metal wire 152 is connected to the first contact part 151. One end of the metal wire 152 is connected to the second contact part 153.

The first contact part 151 is connected to the gate 113 of the first transistor 110, and the second contact part 153 is connected to the source or drain of the second transistor 130.

In this embodiment, one end of the metal wire 152 is connected to the first contact part 151, which may be understood to be that one end of the metal wire 152 is connected to the middle part of the first contact part 151 or that one end of the metal wire 152 is connected to one end of the first contact part 151.

For example, one end of the metal wire 152 may be connected to the end of the first contact part 151 away from the gate 113 of the first transistor 110, and the other end of the metal wire 152 may be connected to the end of the second contact part 153 away from the second transistor 130.

In some embodiments, the first contact part 151 and the metal wire 152 may be located in the first dielectric layer 120. The second contact part 153 may be located in the second dielectric layer 140. However, the foregoing manner is merely a manner to dispose the connecting wire 150. The connecting wire 150 may be further disposed completely in the first dielectric layer 120 or in the second dielectric layer 140.

To prevent the conductive materials in the first dielectric layer 120 and the second dielectric layer 140 from diffusing each other, a barrier layer 160 is also disposed between the first dielectric layer 120 and the second dielectric layer 140. The barrier layer 160 is located on the metal wire 152. The second contact part 153 runs through the barrier layer 160 and is connected to the metal wire 152.

The material of the barrier layer 160 may include an insulation material such as silicon nitride.

### Embodiment 2

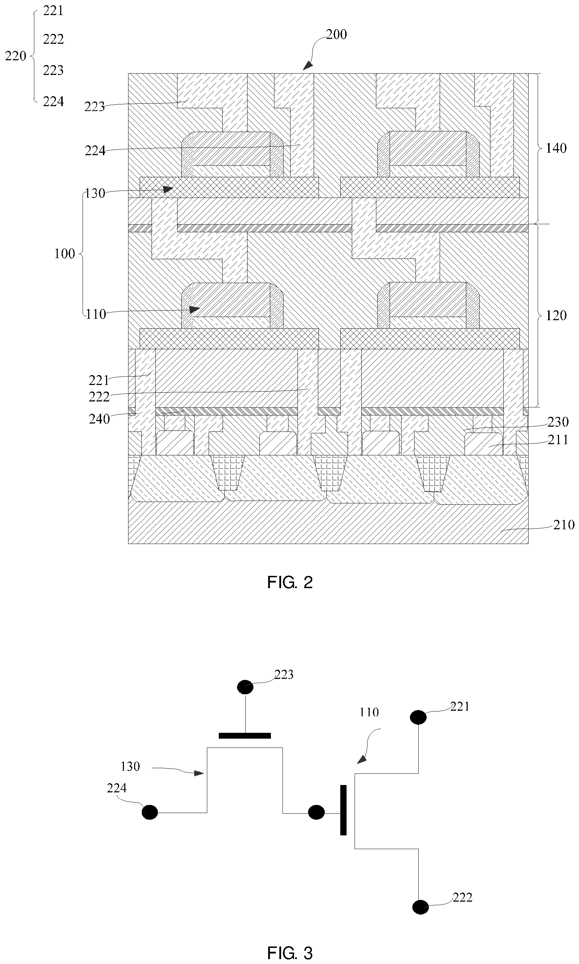

As shown in FIG. 2, this embodiment of the present disclosure further provides a memory 200, which includes a base 210, a memory cell 100 and a data line 220.

The base 210 serves as a support member of a memory and is configured to support other components provided thereon. The base 210 may be made of a semiconductor material. The semiconductor material may be one or more of the group consisting of silicon, germanium, silicon-germanium, and silicon-carbon.

A peripheral circuit 211 is disposed on a surface of the base 210 and may further include a logic circuit or a processing circuit.

A plurality of the memory cells 100 are disposed above the peripheral circuit 211, and the memory cells 100 are connected to the peripheral circuit 211 by using the data line 220.

Compared with the technical solution in the related art that the peripheral circuit is disposed at two sides of the memory cells in a horizontal direction, this embodiment in which the peripheral circuit is disposed below the memory cells can reduce the area of the memory cells, and ensure that the memory is developed in the integration direction.

Further, as shown in FIG. 2, the data line 220 includes a read word line 221, a read bit line 222, a write word line 223 and a write bit line 224.

The write word line 223 and the write bit line 224 can be disposed in the second dielectric layer 140. The write word line 223 extends in the first direction and is connected to the gate of the second transistor 130 in each of the plurality of memory cells 100. The write bit line 224 extends in a second direction and is connected to the source or drain of the second transistor 130 in each of the plurality of memory cells 100, and a joint between the write bit line and the source or drain of the second transistor is different from that between the connecting wire 150 and the source or drain of the second transistor.

In other words, if the connecting wire 150 is connected to the source of the second transistor 130, the write bit line 224 is connected to the drain of the second transistor 130.

The read word line 221 and the read bit line 222 may be disposed in the first dielectric layer 120. The read word line 221 extends in a third direction and is connected to the source or drain of the first transistor 110 in each of the plurality of memory cells 100. The read bit line 222 extends in a fourth direction and is connected to the source or drain of the first transistor 110 in each of the plurality of memory cells 100, and a joint between the read bit line and the source or drain of the first transistor is different from that between the read word line and the source or drain of the first transistor.

In other words, if the read word line 221 is connected to the source of the first transistor 110, the read bit line 222 is correspondingly connected to the drain of the first transistor 110.

Projection of the first direction and that of the second direction on a surface parallel or perpendicular to the base form a first angle, projection of the third direction and that of the fourth direction on a surface parallel or perpendicular to the base form a second angle, and neither the first angle nor the second angle is zero. That is, the write word line and the write bit line are disposed to cross, and the read word line and the read bit line are also disposed to cross.

As shown in FIG. 3, when applied to the write word line 223, a high voltage can be used to control the gate of the second transistor 130 to open, and a voltage difference is generated between the source and the drain of the second transistor 130, to realize conduction between the source and the drain of the second transistor. A voltage on the write bit line 224 works on the gate of the first transistor 110, to write data on the write bit line 224 into the first transistor.

If data in the first transistor needs to be read, the gate of the first transistor 110 is opened, so that the source and drain of the first transistor are opened. In this case, the data in the first transistor 110 is transmitted into the peripheral circuit 211 by using the read bit line 222, and the peripheral circuit 211 processes the data to implement the read function of the memory.

In some embodiments, the plurality of the memory cells 100 are arranged in a direction parallel to the base 210 to form a horizontal array, that is, the plurality of memory cells 100 are disposed sequentially in the horizontal direction. Moreover, the plurality of the memory cells 100 are stacked in a direction perpendicular to the base 210 to form a vertical array. In this way, in this embodiment, the quantity of the memory cells 100 that are arranged sequentially in the horizontal direction can be decreased, an area occupied by the plurality of memory cells can be decreased, and the integration of the memory cells can be improved to ensure that the memory is developed in the integration direction.

In addition, compared with the technical solution in the related art that a plurality of memory cells are arranged in the horizontal direction, the plurality of the memory cells 100 are stacked in a direction perpendicular to the base 210 to form the vertical array, such that the height of the memory is increased, to decrease the width of the memory in the horizontal direction, thereby decreasing the volume of the memory, and improving the integration of the memory cells.

In some embodiments, a peripheral dielectric layer 230 is disposed on the base 210. The peripheral dielectric layer 230 covers the peripheral circuit 211, to electrically isolate the cells in the peripheral circuit 211.

A material of the peripheral dielectric layer 230 may include silicon nitride.

Further, a peripheral barrier layer 240 is also disposed between the peripheral dielectric layer 230 and the first dielectric layer 120 of the memory cell 100. Through such a disposal, the conductive material in the first dielectric layer is prevented from affecting the performance of the peripheral circuit.

When the peripheral barrier layer 240 is disposed between the peripheral dielectric layer 230 and the first dielectric layer 120, the data line 220 needs to run through the peripheral barrier layer 240 and the peripheral dielectric layer 230, and then is connected to the peripheral circuit 211.

### Embodiment 3

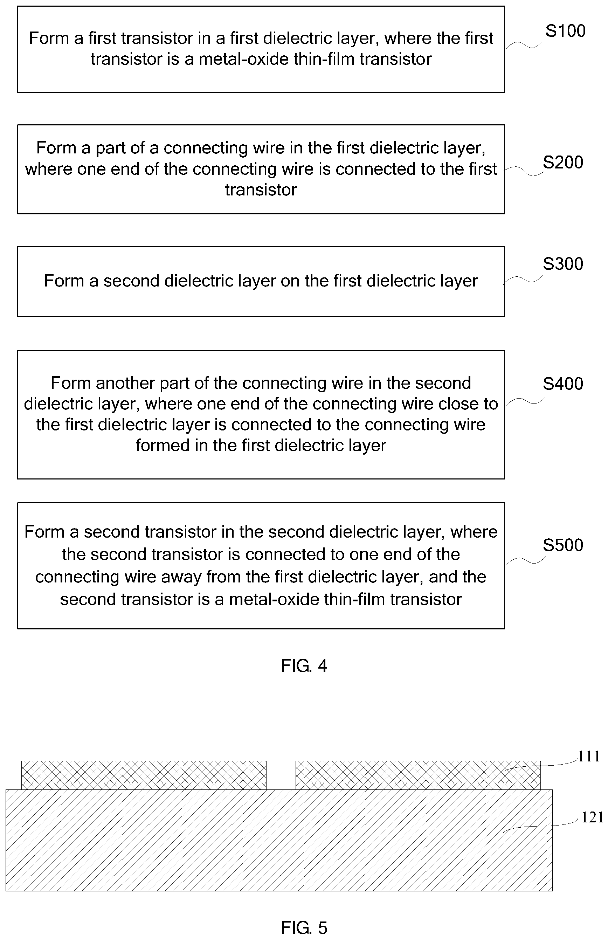

As shown in FIG. 4, this embodiment of the present disclosure further provides a method of manufacturing a memory cell, including:
Step S100: Form a first transistor in a first dielectric layer, wherein the first transistor is a metal-oxide thin-film transistor.

The first dielectric layer 120 may be used as a carrier body of the first transistor 110 or an insulating medium between the first transistor 110 and another member. The material of the first dielectric layer 120 may include silicon oxide or silicon nitride.

The first transistor 110 may be manufactured in the following manners, for example:
Step a: Provide a first insulating layer.

It should be noted that the first insulating layer 121 is a part of the first dielectric layer 120.

Step b: Form an active layer on the first insulating layer, wherein a material of the active layer includes an indium gallium zinc oxide.

For example, as shown in FIG. 5, the active layer 111 may be formed on the first insulating layer 121 by using a deposition process, which may be one of a physical vapor deposition process, a chemical vapor deposition process, or an atomic layer deposition process.

Step c: Form a channel region in the active layer, and a source and a drain respectively located at two sides of the channel region.

In this step, a photoresist layer may be formed on the active layer 111 and then patterned to form an opening therein. The opening can expose a part of the active layer 111. Then, doped ions are injected into the opening by using an ion implantation process, to form a source in the active layer 111.

Through the foregoing process again, a drain is formed in the active layer 111.

Step d: Form a gate oxide layer on the active layer, wherein a length of the gate oxide layer is smaller than that of the active layer.

Silicon oxide or aluminum oxide is deposited by a specific thickness on the active layer 111 through a deposition process. The silicon oxide or aluminum oxide forms the gate oxide layer 112.

Step e: Form a gate on the gate oxide layer, wherein projection of the gate on the active layer covers the channel region.

The deposition process is used continuously to form the gate 113 on the gate oxide layer 112. A material of the gate 113 may be one of the group consisting of titanium nitride, tantalum nitride, aluminum and tungsten.

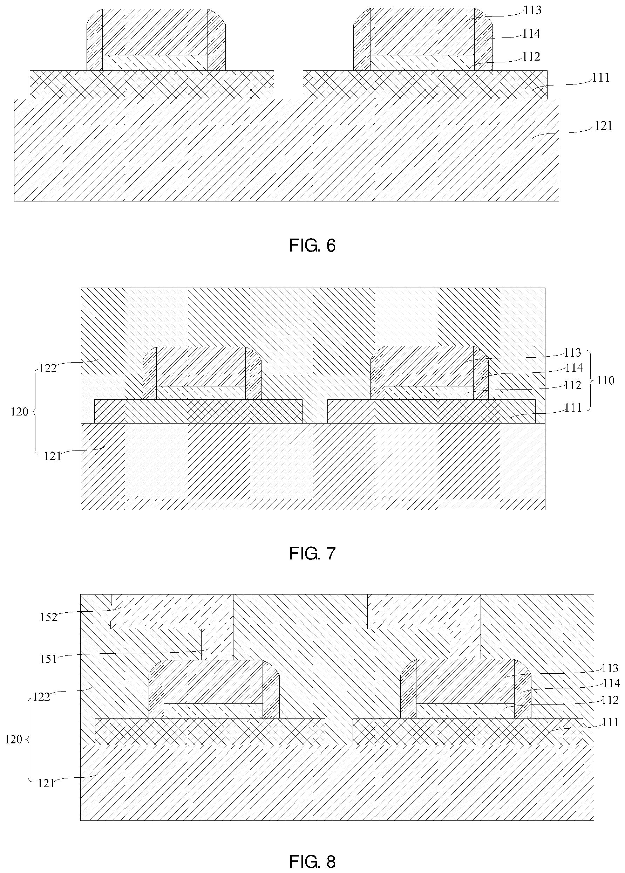

Step f: Form a protective layer on the active layer, wherein the protective layer wraps sides of the gate and of the gate oxide layer, and the structure of the protective layers is shown in FIG. 6.

Initial protective layers may be formed on the active layer through a deposition process. The initial protective layers cover the side surfaces of the gate oxide layer and a top surface and side surfaces of the gate. Then an etching gas or an etching solution is used to remove the initial protective layer on the top surface of the gate, and the initial protective layers on the side surfaces of the gate and of the gate oxide layers are retained to form the protective layers 116.

Step g: Form a second insulating layer covering the active layer, the gate oxide layer, the gate, and the protective layer on the first insulating layer, wherein the second insulating layer and the first insulating layer form the first dielectric layer, and a structure of the first insulating layer is shown in FIG. 7.

Step S200: Form a part of a connecting wire in the first dielectric layer, wherein one end of the connecting wire is connected to the first transistor.

For example, as shown in FIG. 8, a first contact part 151 and a metal wire 152 connected to the first contact part 151 are formed in the second insulating layer 122. The first contact part 151 extends in a vertical direction and is connected to the gate 113 of the first transistor 110. The metal wire 152 extends in a horizontal direction. The first contact part 151 and the metal wire 152 form a part of the connecting wire.

In this step, the first contact part 151 and the metal wire 152 are formed through a dual damascene process or may be formed by using the dual damascene process twice.

It should be noted that in this embodiment, one end of the connecting wire may be understood as one end of the first contact part away from the metal wire.

Step S300: Form a second dielectric layer on the first dielectric layer.

For example, the barrier layer 160 may be formed on the first dielectric layer 120, that is, the barrier layer 160 may be formed first on the second insulating layer 122. The barrier layer is used to prevent conductive materials in the first dielectric layer and the second dielectric layer from diffusing each other.

The materials of the second dielectric layer and the first dielectric layer may be same and both include silicon oxide. The second dielectric layer 140 may include a third insulating layer 141 and a fourth insulating layer 142 that are stacked sequentially. The third insulating layer 141 is disposed on the barrier layer 160.

Step S400: Form another part of the connecting wire in the second dielectric layer, wherein one end of the connecting wire close to the first dielectric layer is connected to the connecting wire formed in the first dielectric layer.

For example, a filled groove may be formed in the second dielectric layer and exposes a part of the metal wire 152. Then a conductive material is formed in the filled groove through a deposition process. The conductive material forms the second contact part 153. The second contact part 153 is connected to the metal wire 152, such that the first contact part 151, the second contact part 153 and the metal wire 152 form the connecting wire.

Step S500: Form a second transistor in the second dielectric layer, wherein the second transistor is connected to one end of the connecting wire away from the first dielectric layer, and the second transistor is a metal-oxide thin-film transistor.

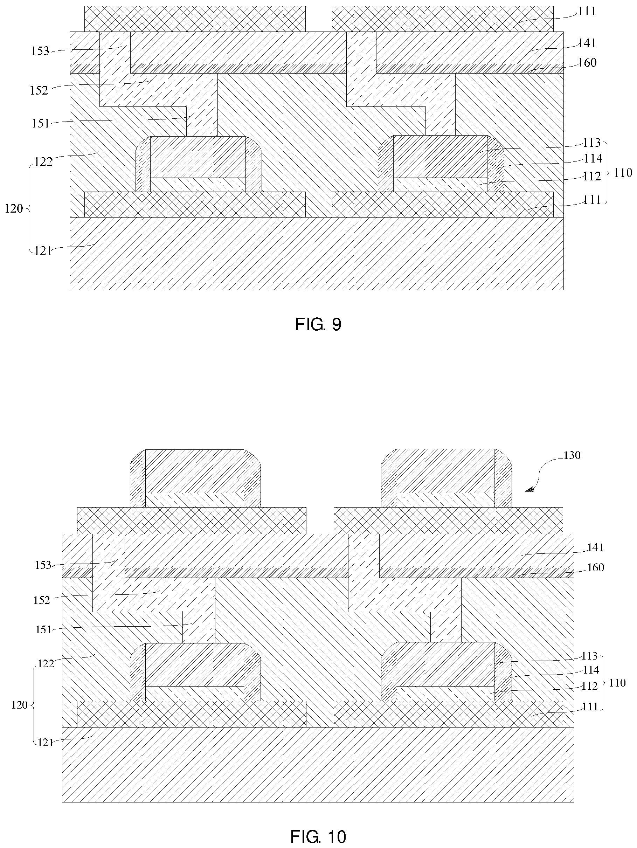

For example, as shown in FIG. 9, the third insulating layer 141 is formed on the first dielectric layer 120.

After the third insulating layer 141 is formed, the active layer 111 may be formed on the third insulating layer 141 through a deposition process. The material of the active layer 111 includes an indium gallium zinc oxide.

It should be noted that the step of forming the active layer on the third insulating layer is the same as that of forming the active layer on the first insulating layer, which is not described in detail again in this embodiment.

Steps c to f are repeated, to form the second transistor 130 on the third insulating layer 141, and the structure of the second transistor is shown in FIG. 10.

After the second transistor 130 is formed, a fourth insulating layer 142 covering the active layer, the gate oxide layer, the gate, and the protective layer is formed on the third insulating layer 141. The fourth insulating layer 142 and the third insulating layer 141 form the second dielectric layer 140.

In this embodiment of the present disclosure, based on the foregoing steps, the first transistor and the second transistor that are stacked are formed, and are used as memory elements of the memory cells to replace the capacitor in the related art, to decrease the volume occupied by the memory cells, improve the integration of the memory cell and ensure that the memory cells are developed in an integration direction.

### Embodiment 4

This embodiment of the present disclosure provides a method of manufacturing a memory, including:
Step S10: Provide a base, wherein a peripheral circuit is disposed on a surface of the base.

In this step, the peripheral circuit may be manufactured by using the method in the related art, which is not described in detail again in this embodiment.

After the peripheral circuit is formed, a peripheral dielectric layer 230 covering the peripheral circuit may be formed on the base.

Then, a peripheral barrier layer 240 may be formed on the peripheral dielectric layer 230 through a deposition process.

Step S20: Form a plurality of memory cells sequentially on the base, wherein the plurality of the memory cells are arranged in a direction parallel to the base to form a horizontal array; and/or the plurality of the memory cells are stacked in a direction perpendicular to the base to form a vertical array.

The memory cells are obtained by using the method of manufacturing a memory cell in the foregoing embodiment, which is not described in detail again in this embodiment.

Step S30: Form a data line, wherein the data line is configured to connect the peripheral circuit to the memory cells.

It should be noted that the data line may be manufactured in two steps. One step may be completed before the first transistor is formed. The other step may be completed after the second transistor is formed.

For example, after the first dielectric layer 120 is formed, a read word line 221 and a read bit line 222 that are insulated from each other may be formed in the first dielectric layer 120. The read word line 221 is configured to be connected to the source or drain of the first transistor 110 in each of the plurality of the memory cells 100, the read bit line 222 is configured to be connected to the source or drain of the first transistor 110 in each of the plurality of the memory cells 100, and a joint between the read bit line and the source or drain of the first transistor is different from that between the read word line 221 and the source or drain of the first transistor.

After the read word line 221 and the read bit line 222 are formed, continuously, the first transistor 110 may be formed in the first dielectric layer 120, a second dielectric layer 140 may be formed on the first dielectric layer 120, and the second transistor 130 may be formed in the second dielectric layer 140.

After the second transistor 130 is formed, the write word line 223 and the write bit line 224 may be formed in the second dielectric layer 140. The write word line 223 is configured to be connected to the gate of the second transistor 130 in each of the plurality of the memory cells 100, the write bit line 224 is configured to be connected to the source or drain of the second transistor 130 in each of the plurality of memory cells 100, and a joint between the write bit line and the source or drain of the second transistor is different from that between the connecting wire 150 and the source or drain of the second transistor.

In this step, the read word line, the read bit line, the write word line, and the write bit line may be all manufactured through the dual damascene process.

Compared with the technical solution in the related art that the plurality of memory cells are arranged sequentially in a horizontal direction, this embodiment in which the plurality of memory cells are stacked in a vertical direction can decrease the area occupied by the memory cells, decrease the size of the memory, and improve the integration of the memory cells.

In addition, compared with the technical solution in the related art that the peripheral circuit is disposed outside the memory cell array, this embodiment in which the peripheral circuit is disposed below the memory cells can further decrease the size of the memory and improve the integration.

The embodiments or implementations of this specification are described in a progressive manner, and each embodiment focuses on differences from other embodiments. The same or similar parts between the embodiments may refer to each other.

In the descriptions of this specification, a description with reference to the term "one implementation", "some implementations", "an exemplary implementation", "an example", "a specific example", "some examples", or the like means that a specific feature, structure, material, or characteristic described in combination with the implementation(s) or example(s) is included in at least one implementation or example of the present disclosure.

In this specification, the schematic expression of the above terms does not necessarily refer to the same embodiment or example. Moreover, the described specific feature, structure, material or characteristic may be combined in an appropriate manner in any one or more embodiments or examples.

Finally, it should be noted that the foregoing embodiments are used only to explain the technical solutions of the present disclosure, but are not intended to limit the present disclosure. Although the present disclosure is described in detail with reference to the foregoing embodiments, those of ordinary skill in the art should understand that they can still modify the technical solutions described in the foregoing embodiments, or make equivalent substitutions on some or all technical features therein. The modifications or substitutions do not make the essence of the corresponding technical solutions deviate from the spirit and scope of the technical solutions of the embodiments of the present disclosure.

## Claims

1. A memory cell, comprising:
a first transistor, located in a first dielectric layer;
a second transistor, located in a second dielectric layer, wherein the second dielectric layer is located above the first dielectric layer; and
a connecting wire, located in the first dielectric layer and the second dielectric layer, wherein one end of the connecting wire is connected to the first transistor, and the other end is connected to the second transistor; and
the first transistor and the second transistor are metal-oxide thin-film transistors.

2. The memory cell according to claim 1, wherein the first transistor and the second transistor each comprise:
an active layer, wherein a material of the active layer comprises an indium gallium zinc oxide, and the active layer comprises a channel region, and a source and a drain that are respectively located at two sides of the channel region;
a gate oxide layer, disposed on the active layer; and
a gate, disposed on the gate oxide layer, wherein projection of the gate on the active layer covers the channel region.

3. The memory cell according to claim 2, wherein the first transistor and the second transistor each further comprise a protective layer, wherein the protective layer is located at sides of the gate and of the gate oxide layer.

4. The memory cell according to claim 2, wherein the connecting wire has one end connected to the gate of the first transistor, and the other end connected to the source or drain of the second transistor.

5. The memory cell according to claim 4, wherein the connecting wire comprises a first contact part and a second contact part that are disposed vertically and a metal wire disposed horizontally; and
the first contact part is connected to the gate of the first transistor, the second contact part is connected to the source or drain of the second transistor, and the metal wire connects the first contact part to the second contact part.

6. The memory cell according to claim 5, wherein the first contact part and the metal wire are located in the first dielectric layer, and the second contact part is located in the second dielectric layer.

7. The memory cell according to claim 5 or 6, wherein a barrier layer is disposed between the first dielectric layer and the second dielectric layer, the barrier layer is located on the metal wire, and the second contact part is in contact with the metal wire and runs through the barrier layer.

8. A memory, comprising:
a base, wherein a peripheral circuit is disposed on a surface of the base;
a plurality of the memory cells according to any one of claims 1 to 7, located above the peripheral circuit; and
a data line, configured to connect the peripheral circuit to the plurality of the memory cells.

9. The memory according to claim 8, wherein the plurality of the memory cells are arranged in a direction parallel to the base to form a horizontal array; and/or
the plurality of the memory cells are stacked in a direction perpendicular to the base to form a vertical array.

10. The memory according to claim 8, wherein the data line comprises a write word line, a write bit line, a read word line and a read bit line; and
the write word line extends in a first direction and is connected to the gate of the second transistor in each of the plurality of memory cells, the write bit line extends in a second direction and is connected to the source or drain of the second transistor in each of the plurality of memory cells, and a joint between the write bit line and the source or drain of the second transistor is different from a joint between the connecting wire and the source or drain of the second transistor, the read word line extends in a third direction and is connected to the source or drain of the first transistor in each of the plurality of memory cells, the read bit line extends in a fourth direction and is connected to the source or drain of the first transistor in each of the plurality of memory cells, and a joint between the read bit line and the source or drain of the first transistor is different from a joint between the read word line and the source or drain of the first transistor.

11. The memory according to claim 10, wherein projection of the first direction and projection of the second direction on a surface parallel or perpendicular to the base form a first angle, projection of the third direction and projection of the fourth direction on a surface parallel or perpendicular to the base form a second angle, and neither the first angle nor the second angle is zero.

12. The memory according to claim 8, wherein a peripheral dielectric layer is disposed on the base, and the peripheral dielectric layer covers the peripheral circuit; and
a peripheral barrier layer is further disposed between the peripheral dielectric layer and the first dielectric layer of the memory cell.

13. The memory according to any one of claim 12, wherein the data line runs through the peripheral barrier layer and the peripheral dielectric layer, and is connected to the peripheral circuit.

14. A method of manufacturing a memory cell, comprising:
forming a first transistor in a first dielectric layer, wherein the first transistor is a metal-oxide thin-film transistor;
forming a part of a connecting wire in the first dielectric layer, wherein one end of the connecting wire is connected to the first transistor;
forming a second dielectric layer on the first dielectric layer;
forming another part of the connecting wire in the second dielectric layer, wherein one end of the connecting wire close to the first dielectric layer is connected to the connecting wire formed in the first dielectric layer; and
forming a second transistor in the second dielectric layer, wherein the second transistor is connected to one end of the connecting wire away from the first dielectric layer, and the second transistor is a metal-oxide thin-film transistor.

15. The method of manufacturing a memory cell according to claim 14, wherein the forming a first transistor in a first dielectric layer comprises:
step a: providing a first insulating layer;
step b: forming an active layer on the first insulating layer, wherein a material of the active layer comprises an indium gallium zinc oxide;
step c: forming a channel region in the active layer, and a source and a drain respectively located at two sides of the channel region;
step d: forming a gate oxide layer on the active layer, wherein a length of the gate oxide layer is smaller than a length of the active layer;
step e: forming a gate on the gate oxide layer, wherein projection of the gate on the active layer covers the channel region;
step f: forming a protective layer on the active layer, wherein the protective layer wraps sides of the gate and of the gate oxide layer; and
step g: forming a second insulating layer covering the active layer, the gate oxide layer, the gate, and the protective layer on the first insulating layer, wherein the second insulating layer and the first insulating layer form the first dielectric layer.

16. The method of manufacturing a memory cell according to claim 15, wherein the forming a part of a connecting wire in the first dielectric layer, wherein one end of the connecting wire is connected to the first transistor comprises:
forming a first contact part and a metal wire connected to the first contact part in the second insulating layer, wherein the first contact part extends in a vertical direction and is connected to the gate of the first transistor, and the metal line extends in a horizontal direction.

17. The method of manufacturing a memory cell according to claim 16, wherein the forming a second transistor in the second dielectric layer comprises:
forming a third insulating layer on the first dielectric layer;
forming an active layer on the third insulating layer, wherein a material of the active layer comprises an indium gallium zinc oxide;
repeating steps c to f, to form the second transistor on the third insulating layer; and
forming a fourth insulating layer covering the active layer, the gate oxide layer, the gate, and the protective layer on the third insulating layer, wherein the fourth insulating layer and the third insulating layer form the second dielectric layer.

18. The method of manufacturing a memory cell according to any one of claims 15 to 17, wherein after the first contact part is formed in the second insulating layer and before the second contact part is formed in the second dielectric layer, the method further comprises:
forming a barrier layer on the second insulating layer.

19. A method of manufacturing a memory, comprising:
providing a base, wherein a peripheral circuit is disposed on a surface of the base;
forming a plurality of memory cells sequentially on the base, wherein the plurality of the memory cells are arranged in a direction parallel to the base to form a horizontal array; and/or the plurality of the memory cells are stacked in a direction perpendicular to the base to form a vertical array; and the memory cell is obtained by using the method of manufacturing a memory cell according to any one of claims 14 to 18; and
forming a data line, wherein the data line is configured to connect the peripheral circuit to the memory cells.

20. The method of manufacturing a memory according to claim 19, wherein the forming a data line comprises:
forming a read word line and a read bit line that are insulated from each other in the first dielectric layer, wherein the read word line is configured to be connected to the source or drain of the first transistor in each of the plurality of the memory cells, the read bit line is configured to be connected to the source or drain of the first transistor in each of the plurality of the memory cells, and a joint between the read bit line and the source or drain of the first transistor is different from a joint between the read word line and the source or drain of the first transistor; and
forming a write word line and a write bit line in the second dielectric layer, wherein the write word line is configured to be connected to the gate of the second transistor in each of the plurality of the memory cells, the write bit line is configured to be connected to the source or drain of the second transistor in each of the plurality of memory cells, and a joint between the write bit line and the source or drain of the second transistor is different from a joint between the connecting wire and the source or drain of the second transistor.
